# EUROPEAN PATENT APPLICATION

(11) **EP 3 708 288 A1**
(43) Date of publication of application: **16.09.2020**
(21) Application number: 20162763.5
(22) Date of filing: 12.03.2020
(51) Int. Cl.: B23K 20/02, B23K 20/16, B23K 20/233, B23K 35/00, B23K 35/30, B32B 15/01, B23K 35/02

(54) **METHOD OF FORMING A DIFFUSION BONDED JOINT**

(30) Priority: 12.03.2019 GB 201903373
(71) Applicant: Rolls-Royce plc, London N1 9FX (GB)
(72) Inventor: Clark, Daniel, Derby, Derbyshire DE24 8BJ (GB)
(74) Representative: Rolls-Royce plc

(57) **Abstract**

A method of forming a diffusion bonded joint comprises the steps of: providing a first component having a first faying surface; providing a second component having a second faying surface; applying a lamellar coating to at least one of the first faying surface and the second faying surface; and bringing the first and second faying surfaces into contact in a diffusion bonding operation to form the diffusion bonded joint.

## Description

The present disclosure relates to a method of forming a diffusion bonded joint. The method can reduce the background temperature required for diffusion bonding compared to conventional techniques.

In precision manufacturing operations such as in the aerospace industry, it is important to join components effectively. However, some materials, such as nickel based superalloys can require particular care of handling and may, for example become sensitive to cracking at high temperatures close to the melting temperature. Such considerations can constrain the use of certain joining methods, such as fusion welding and conventional diffusion bonding. Similarly, high temperature flow stress can impair upset during a friction welding.

One possible joining option that might be considered is friction welding. However this is highly capital intensive and has geometrical limitation which can affect design freedom and hence performance.

According to a first aspect of the disclosure there is provided a method of forming a diffusion bonded joint, the method comprising one or more of the steps of: providing a first component having a first faying surface; providing a second component having a second faying surface; applying a lamellar coating to at least one of the first faying surface and the second faying surface, the lamellar coating comprising a plurality of layers of differing composition, the layers of the lamellar coating being composed of the same elements as the bulk material of one or more of the first component and the second component, the lamellar coating having substantially the same ratio of elements as the bulk material of one or more of the first component and the second component; and bringing the first and second faying surfaces into contact in a diffusion bonding operation to form the diffusion bonded joint.

Optionally, the lamellar coating comprises adjacent layers respectively comprising elements with different atomic radii. Adjacent layers in the lamellar coating can comprise elements having a ratio of atomic radii of 1.15 or more, the ratio being defined as the ratio of larger elements to smaller elements based on calculated atomic radii, optionally 1.18 or more. The ratio may be defined based on calculated atomic radii, such as the well know Clementi values.

Optionally, the lamellar coating has a thickness of from 10 to 70 microns, further optionally from 20 to 60 microns, still further optionally from 30 to 50 microns.

Optionally, individual layers within the lamellar coating each have a thickness of from 0.10 to 1.25 microns, further optionally from 0.40 to 1.10 microns, and still further optionally from 0.50 to 1.00 microns.

Optionally, individual layers within the lamellar coating are formed by electron beam physical vapour deposition.

Optionally, the method further comprises applying the lamellar coating in a vacuum.

Optionally, the method further comprises maintaining the first and second faying surfaces in a vacuum between the step of applying the lamellar coating and the step of bringing the first and second faying surfaces into contact in a diffusion bonding operation.

Optionally, the diffusion bonding operation is initiated by a local heat source at a part of the joint, such as a chemical or electrical fuse. Optionally, the method further comprises removing the part of the joint at which the local heat source was applied.

Optionally, the diffusion bonding operation is performed under isostatic pressure.

Optionally, the lamellar coating comprises a layer of transition metal adjacent to a layer of transition metal enriched with Zirconium, adjacent to a further layer of transition metal, adjacent to a layer of transition metal enriched with Aluminium.

Optionally, the lamellar coating comprises a layer of transition metal adjacent to a layer of transition metal enriched with Tantalum, adjacent to a further layer of transition metal, adjacent to a layer of transition metal enriched with Boron.

Optionally, the lamellar coating comprises a layer of transition metal adjacent to a layer of transition metal enriched with Tungsten, adjacent to a second layer of transition metal, adjacent to a layer of transition metal enriched with Titanium, adjacent to a third layer of transition metal, adjacent to a layer of transition metal enriched with Carbon.

According to a second aspect of the disclosure, there is provided a diffusion bonded joint formed according to the first aspect.

According to a third aspect of the disclosure, there is provided a component for a gas turbine engine comprising a diffusion bonded joint according to the second aspect.

According to a fourth aspect of the disclosure, there is provided an engine for an aircraft comprising: an engine core comprising a turbine, a compressor, and a core shaft connecting the turbine to the compressor; a fan located upstream of the engine core, the fan comprising a plurality of fan blades; and a gearbox that receives an input from the core shaft and outputs drive to the fan so as to drive the fan at a lower rotational speed than the core shaft, wherein the gas turbine engine comprises a diffusion bond according to the second aspect.

Optionally, the turbine is a first turbine, the compressor is a first compressor, and the core shaft is a first core shaft; the engine core further comprises a second turbine, a second compressor, and a second core shaft connecting the second turbine to the second compressor; and the second turbine, second compressor, and second core shaft are arranged to rotate at a higher rotational speed than the first core shaft.

As noted elsewhere herein, the present disclosure may relate to a gas turbine engine. Such a gas turbine engine may comprise an engine core comprising a turbine, a combustor, a compressor, and a core shaft connecting the turbine to the compressor. Such a gas turbine engine may comprise a fan (having fan blades) located upstream of the engine core.

Arrangements of the present disclosure may be particularly, although not exclusively, beneficial for fans that are driven via a gearbox. Accordingly, the gas turbine engine may comprise a gearbox that receives an input from the core shaft and outputs drive to the fan so as to drive the fan at a lower rotational speed than the core shaft. The input to the gearbox may be directly from the core shaft, or indirectly from the core shaft, for example via a spur shaft and/or gear. The core shaft may rigidly connect the turbine and the compressor, such that the turbine and compressor rotate at the same speed (with the fan rotating at a lower speed).

The gas turbine engine as described and/or claimed herein may have any suitable general architecture. For example, the gas turbine engine may have any desired number of shafts that connect turbines and compressors, for example one, two or three shafts. Purely by way of example, the turbine connected to the core shaft may be a first turbine, the compressor connected to the core shaft may be a first compressor, and the core shaft may be a first core shaft. The engine core may further comprise a second turbine, a second compressor, and a second core shaft connecting the second turbine to the second compressor. The second turbine, second compressor, and second core shaft may be arranged to rotate at a higher rotational speed than the first core shaft.

In such an arrangement, the second compressor may be positioned axially downstream of the first compressor. The second compressor may be arranged to receive (for example directly receive, for example via a generally annular duct) flow from the first compressor.

The gearbox may be arranged to be driven by the core shaft that is configured to rotate (for example in use) at the lowest rotational speed (for example the first core shaft in the example above). For example, the gearbox may be arranged to be driven only by the core shaft that is configured to rotate (for example in use) at the lowest rotational speed (for example only be the first core shaft, and not the second core shaft, in the example above). Alternatively, the gearbox may be arranged to be driven by any one or more shafts, for example the first and/or second shafts in the example above.

In any gas turbine engine as described and/or claimed herein, a combustor may be provided axially downstream of the fan and compressor(s). For example, the combustor may be directly downstream of (for example at the exit of) the second compressor, where a second compressor is provided. By way of further example, the flow at the exit to the combustor may be provided to the inlet of the second turbine, where a second turbine is provided. The combustor may be provided upstream of the turbine(s).

The or each compressor (for example the first compressor and second compressor as described above) may comprise any number of stages, for example multiple stages. Each stage may comprise a row of rotor blades and a row of stator vanes, which may be variable stator vanes (in that their angle of incidence may be variable). The row of rotor blades and the row of stator vanes may be axially offset from each other.

The or each turbine (for example the first turbine and second turbine as described above) may comprise any number of stages, for example multiple stages. Each stage may comprise a row of rotor blades and a row of stator vanes. The row of rotor blades and the row of stator vanes may be axially offset from each other.

Each fan blade may be defined as having a radial span extending from a root (or hub) at a radially inner gas-washed location, or 0% span position, to a tip at a 100% span position. The ratio of the radius of the fan blade at the hub to the radius of the fan blade at the tip may be less than (or on the order of) any of: 0.4, 0.39, 0.38 0.37, 0.36, 0.35, 0.34, 0.33, 0.32, 0.31, 0.3, 0.29, 0.28, 0.27, 0.26, or 0.25. The ratio of the radius of the fan blade at the hub to the radius of the fan blade at the tip may be in an inclusive range bounded by any two of the values in the previous sentence (i.e. the values may form upper or lower bounds). These ratios may commonly be referred to as the hub-to-tip ratio. The radius at the hub and the radius at the tip may both be measured at the leading edge (or axially forwardmost) part of the blade. The hub-to-tip ratio refers, of course, to the gas-washed portion of the fan blade, i.e. the portion radially outside any platform.

The radius of the fan may be measured between the engine centreline and the tip of a fan blade at its leading edge. The fan diameter (which may simply be twice the radius of the fan) may be greater than (or on the order of) any of: 250 cm (around 100 inches), 260 cm, 270 cm (around 105 inches), 280 cm (around 110 inches), 290 cm (around 115 inches), 300 cm (around 120 inches), 310 cm, 320 cm (around 125 inches), 330 cm (around 130 inches), 340 cm (around 135 inches), 350cm, 360cm (around 140 inches), 370 cm (around 145 inches), 380 (around 150 inches) cm or 390 cm (around 155 inches). The fan diameter may be in an inclusive range bounded by any two of the values in the previous sentence (i.e. the values may form upper or lower bounds).

The rotational speed of the fan may vary in use. Generally, the rotational speed is lower for fans with a higher diameter. Purely by way of non-limitative example, the rotational speed of the fan at cruise conditions may be less than 2500 rpm, for example less than 2300 rpm. Purely by way of further non-limitative example, the rotational speed of the fan at cruise conditions for an engine having a fan diameter in the range of from 250 cm to 300 cm (for example 250 cm to 280 cm) may be in the range of from 1700 rpm to 2500 rpm, for example in the range of from 1800 rpm to 2300 rpm, for example in the range of from 1900 rpm to 2100 rpm. Purely by way of further non-limitative example, the rotational speed of the fan at cruise conditions for an engine having a fan diameter in the range of from 320 cm to 380 cm may be in the range of from 1200 rpm to 2000 rpm, for example in the range of from 1300 rpm to 1800 rpm, for example in the range of from 1400 rpm to 1600 rpm.

In use of the gas turbine engine, the fan (with associated fan blades) rotates about a rotational axis. This rotation results in the tip of the fan blade moving with a velocity Utip. The work done by the fan blades 13 on the flow results in an enthalpy rise dH of the flow. A fan tip loading may be defined as dH/Utip2, where dH is the enthalpy rise (for example the 1-D average enthalpy rise) across the fan and Utip is the (translational) velocity of the fan tip, for example at the leading edge of the tip (which may be defined as fan tip radius at leading edge multiplied by angular speed). The fan tip loading at cruise conditions may be greater than (or on the order of) any of: 0.3, 0.31, 0.32, 0.33, 0.34, 0.35, 0.36, 0.37, 0.38, 0.39 or 0.4 (all units in this paragraph being Jkg-1K-1/(ms-1)2). The fan tip loading may be in an inclusive range bounded by any two of the values in the previous sentence (i.e. the values may form upper or lower bounds).

Gas turbine engines in accordance with the present disclosure may have any desired bypass ratio, where the bypass ratio is defined as the ratio of the mass flow rate of the flow through the bypass duct to the mass flow rate of the flow through the core at cruise conditions. In some arrangements the bypass ratio may be greater than (or on the order of) any of the following: 10, 10.5, 11, 11.5, 12, 12.5, 13, 13.5, 14, 14.5, 15, 15.5, 16, 16.5, or 17. The bypass ratio may be in an inclusive range bounded by any two of the values in the previous sentence (i.e. the values may form upper or lower bounds). The bypass duct may be substantially annular. The bypass duct may be radially outside the core engine. The radially outer surface of the bypass duct may be defined by a nacelle and/or a fan case.

The overall pressure ratio of a gas turbine engine as described and/or claimed herein may be defined as the ratio of the stagnation pressure upstream of the fan to the stagnation pressure at the exit of the highest pressure compressor (before entry into the combustor). By way of non-limitative example, the overall pressure ratio of a gas turbine engine as described and/or claimed herein at cruise may be greater than (or on the order of) any of the following: 35, 40, 45, 50, 55, 60, 65, 70, 75. The overall pressure ratio may be in an inclusive range bounded by any two of the values in the previous sentence (i.e. the values may form upper or lower bounds).

Specific thrust of an engine may be defined as the net thrust of the engine divided by the total mass flow through the engine. At cruise conditions, the specific thrust of an engine described and/or claimed herein may be less than (or on the order of) any of the following: 110 Nkg-1s, 105 Nkg-1s, 100 Nkg-1s, 95 Nkg-1s, 90 Nkg-1s, 85 Nkg-1s or 80 Nkg-1s. The specific thrust may be in an inclusive range bounded by any two of the values in the previous sentence (i.e. the values may form upper or lower bounds). Such engines may be particularly efficient in comparison with conventional gas turbine engines.

A gas turbine engine as described and/or claimed herein may have any desired maximum thrust. Purely by way of non-limitative example, a gas turbine as described and/or claimed herein may be capable of producing a maximum thrust of at least (or on the order of) any of the following: 160kN, 170kN, 180kN, 190kN, 200kN, 250kN, 300kN, 350kN, 400kN, 450kN, 500kN, or 550kN. The maximum thrust may be in an inclusive range bounded by any two of the values in the previous sentence (i.e. the values may form upper or lower bounds). The thrust referred to above may be the maximum net thrust at standard atmospheric conditions at sea level plus 15 deg C (ambient pressure 101.3kPa, temperature 30 deg C), with the engine static.

In use, the temperature of the flow at the entry to the high pressure turbine may be particularly high. This temperature, which may be referred to as TET, may be measured at the exit to the combustor, for example immediately upstream of the first turbine vane, which itself may be referred to as a nozzle guide vane. At cruise, the TET may be at least (or on the order of) any of the following: 1400K, 1450K, 1500K, 1550K, 1600K or 1650K. The TET at cruise may be in an inclusive range bounded by any two of the values in the previous sentence (i.e. the values may form upper or lower bounds). The maximum TET in use of the engine may be, for example, at least (or on the order of) any of the following: 1700K, 1750K, 1800K, 1850K, 1900K, 1950K or 2000K. The maximum TET may be in an inclusive range bounded by any two of the values in the previous sentence (i.e. the values may form upper or lower bounds). The maximum TET may occur, for example, at a high thrust condition, for example at a maximum take-off (MTO) condition.

A fan blade and/or aerofoil portion of a fan blade described and/or claimed herein may be manufactured from any suitable material or combination of materials. For example at least a part of the fan blade and/or aerofoil may be manufactured at least in part from a composite, for example a metal matrix composite and/or an organic matrix composite, such as carbon fibre. By way of further example at least a part of the fan blade and/or aerofoil may be manufactured at least in part from a metal, such as a titanium based metal or an aluminium based material (such as an aluminium-lithium alloy) or a steel based material. The fan blade may comprise at least two regions manufactured using different materials. For example, the fan blade may have a protective leading edge, which may be manufactured using a material that is better able to resist impact (for example from birds, ice or other material) than the rest of the blade. Such a leading edge may, for example, be manufactured using titanium or a titanium-based alloy. Thus, purely by way of example, the fan blade may have a carbonfibre or aluminium based body (such as an aluminium lithium alloy) with a titanium leading edge.

A fan as described and/or claimed herein may comprise a central portion, from which the fan blades may extend, for example in a radial direction. The fan blades may be attached to the central portion in any desired manner. For example, each fan blade may comprise a fixture which may engage a corresponding slot in the hub (or disc). Purely by way of example, such a fixture may be in the form of a dovetail that may slot into and/or engage a corresponding slot in the hub/disc in order to fix the fan blade to the hub/disc. By way of further example, the fan blades maybe formed integrally with a central portion. Such an arrangement may be referred to as a blisk or a bling. Any suitable method may be used to manufacture such a blisk or bling. For example, at least a part of the fan blades may be machined from a block and/or at least part of the fan blades may be attached to the hub/disc by welding, such as linear friction welding.

The gas turbine engines described and/or claimed herein may or may not be provided with a variable area nozzle (VAN). Such a variable area nozzle may allow the exit area of the bypass duct to be varied in use. The general principles of the present disclosure may apply to engines with or without a VAN.

The fan of a gas turbine as described and/or claimed herein may have any desired number of fan blades, for example 16, 18, 20, or 22 fan blades.

As used herein, cruise conditions may mean cruise conditions of an aircraft to which the gas turbine engine is attached. Such cruise conditions may be conventionally defined as the conditions at mid-cruise, for example the conditions experienced by the aircraft and/or engine at the midpoint (in terms of time and/or distance) between top of climb and start of decent.

Purely by way of example, the forward speed at the cruise condition may be any point in the range of from Mach 0.7 to 0.9, for example 0.75 to 0.85, for example 0.76 to 0.84, for example 0.77 to 0.83, for example 0.78 to 0.82, for example 0.79 to 0.81, for example on the order of Mach 0.8, on the order of Mach 0.85 or in the range of from 0.8 to 0.85. Any single speed within these ranges may be the cruise condition. For some aircraft, the cruise conditions may be outside these ranges, for example below Mach 0.7 or above Mach 0.9.

Purely by way of example, the cruise conditions may correspond to standard atmospheric conditions at an altitude that is in the range of from 10000m to 15000m, for example in the range of from 10000m to 12000m, for example in the range of from 10400m to 11600m (around 38000 ft), for example in the range of from 10500m to 11500m, for example in the range of from 10600m to 11400m, for example in the range of from 10700m (around 35000 ft) to 11300m, for example in the range of from 10800m to 11200m, for example in the range of from 10900m to 11100m, for example on the order of 11000m. The cruise conditions may correspond to standard atmospheric conditions at any given altitude in these ranges.

Purely by way of example, the cruise conditions may correspond to: a forward Mach number of 0.8; a pressure of 23000 Pa; and a temperature of -55 deg C.

As used anywhere herein, "cruise" or "cruise conditions" may mean the aerodynamic design point. Such an aerodynamic design point (or ADP) may correspond to the conditions (comprising, for example, one or more of the Mach Number, environmental conditions and thrust requirement) for which the fan is designed to operate. This may mean, for example, the conditions at which the fan (or gas turbine engine) is designed to have optimum efficiency.

In use, a gas turbine engine described and/or claimed herein may operate at the cruise conditions defined elsewhere herein. Such cruise conditions may be determined by the cruise conditions (for example the mid-cruise conditions) of an aircraft to which at least one (for example 2 or 4) gas turbine engine may be mounted in order to provide propulsive thrust.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

Embodiments will now be described by way of example only, with reference to the Figures, in which:
Figure 1 is a sectional side view of a gas turbine engine;
Figure 2 is a close up sectional side view of an upstream portion of a gas turbine engine;
Figure 3 is a partially cut-away view of a gearbox for a gas turbine engine; and
Figure 4 is a schematic representation of a process for creating a diffusion bond in a localised encapsulation arrangement.

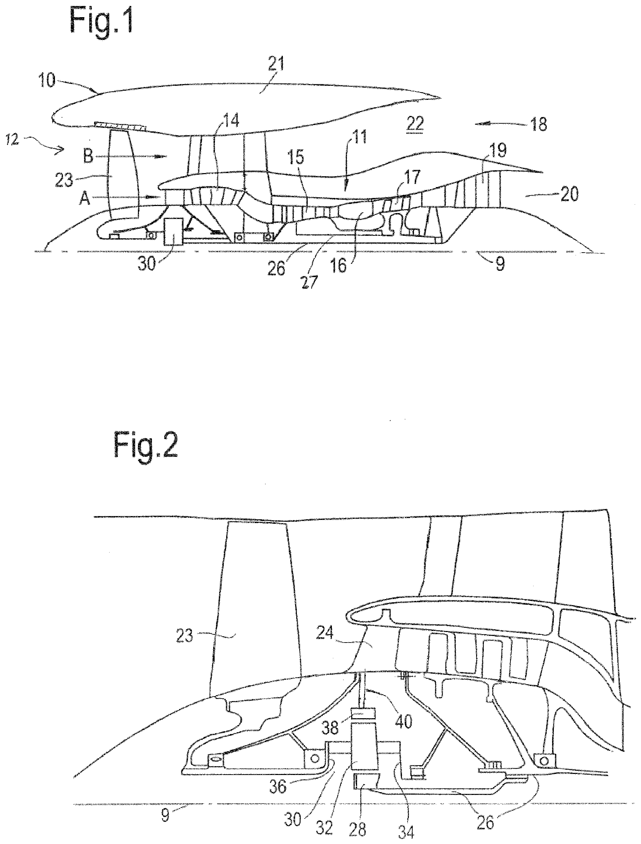

Figure 1 illustrates a gas turbine engine 10 having a principal rotational axis 9. The engine 10 comprises an air intake 12 and a propulsive fan 23 that generates two airflows: a core airflow A and a bypass airflow B. The gas turbine engine 10 comprises a core 11 that receives the core airflow A. The engine core 11 comprises, in axial flow series, a low pressure compressor 14, a high-pressure compressor 15, combustion equipment 16, a high-pressure turbine 17, a low pressure turbine 19 and a core exhaust nozzle 20. A nacelle 21 surrounds the gas turbine engine 10 and defines a bypass duct 22 and a bypass exhaust nozzle 18. The bypass airflow B flows through the bypass duct 22. The fan 23 is attached to and driven by the low pressure turbine 19 via a shaft 26 and an epicyclic gearbox 30.

In use, the core airflow A is accelerated and compressed by the low pressure compressor 14 and directed into the high pressure compressor 15 where further compression takes place. The compressed air exhausted from the high pressure compressor 15 is directed into the combustion equipment 16 where it is mixed with fuel and the mixture is combusted. The resultant hot combustion products then expand through, and thereby drive, the high pressure and low pressure turbines 17, 19 before being exhausted through the nozzle 20 to provide some propulsive thrust. The high pressure turbine 17 drives the high pressure compressor 15 by a suitable interconnecting shaft 27. The fan 23 generally provides the majority of the propulsive thrust. The epicyclic gearbox 30 is a reduction gearbox.

An exemplary arrangement for a geared fan gas turbine engine 10 is shown in Figure 2. The low pressure turbine 19 (see Figure 1) drives the shaft 26, which is coupled to a sun wheel, or sun gear, 28 of the epicyclic gear arrangement 30. Radially outwardly of the sun gear 28 and intermeshing therewith is a plurality of planet gears 32 that are coupled together by a planet carrier 34. The planet carrier 34 constrains the planet gears 32 to precess around the sun gear 28 in synchronicity whilst enabling each planet gear 32 to rotate about its own axis. The planet carrier 34 is coupled via linkages 36 to the fan 23 in order to drive its rotation about the engine axis 9. Radially outwardly of the planet gears 32 and intermeshing therewith is an annulus or ring gear 38 that is coupled, via linkages 40, to a stationary supporting structure 24.

Note that the terms "low pressure turbine" and "low pressure compressor" as used herein may be taken to mean the lowest pressure turbine stages and lowest pressure compressor stages (i.e. not including the fan 23) respectively and/or the turbine and compressor stages that are connected together by the interconnecting shaft 26 with the lowest rotational speed in the engine (i.e. not including the gearbox output shaft that drives the fan 23). In some literature, the "low pressure turbine" and "low pressure compressor" referred to herein may alternatively be known as the "intermediate pressure turbine" and "intermediate pressure compressor". Where such alternative nomenclature is used, the fan 23 may be referred to as a first, or lowest pressure, compression stage.

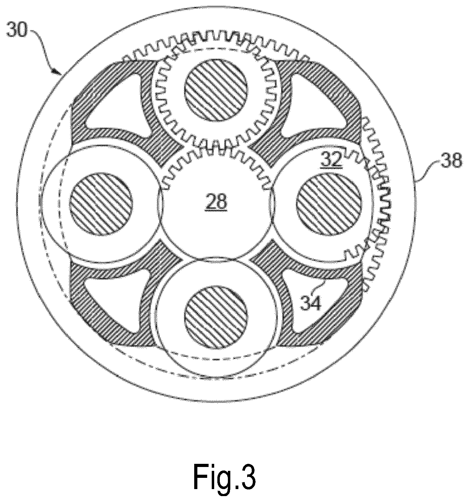

The epicyclic gearbox 30 is shown by way of example in greater detail in Figure 3. Each of the sun gear 28, planet gears 32 and ring gear 38 comprise teeth about their periphery to intermesh with the other gears. However, for clarity only exemplary portions of the teeth are illustrated in Figure 3. There are four planet gears 32 illustrated, although it will be apparent to the skilled reader that more or fewer planet gears 32 may be provided within the scope of the claimed invention. Practical applications of a planetary epicyclic gearbox 30 generally comprise at least three planet gears 32.

The epicyclic gearbox 30 illustrated by way of example in Figures 2 and 3 is of the planetary type, in that the planet carrier 34 is coupled to an output shaft via linkages 36, with the ring gear 38 fixed. However, any other suitable type of epicyclic gearbox 30 may be used. By way of further example, the epicyclic gearbox 30 may be a star arrangement, in which the planet carrier 34 is held fixed, with the ring (or annulus) gear 38 allowed to rotate. In such an arrangement the fan 23 is driven by the ring gear 38. By way of further alternative example, the gearbox 30 may be a differential gearbox in which the ring gear 38 and the planet carrier 34 are both allowed to rotate.

It will be appreciated that the arrangement shown in Figures 2 and 3 is by way of example only, and various alternatives are within the scope of the present disclosure. Purely by way of example, any suitable arrangement may be used for locating the gearbox 30 in the engine 10 and/or for connecting the gearbox 30 to the engine 10. By way of further example, the connections (such as the linkages 36, 40 in the Figure 2 example) between the gearbox 30 and other parts of the engine 10 (such as the input shaft 26, the output shaft and the fixed structure 24) may have any desired degree of stiffness or flexibility. By way of further example, any suitable arrangement of the bearings between rotating and stationary parts of the engine (for example between the input and output shafts from the gearbox and the fixed structures, such as the gearbox casing) may be used, and the disclosure is not limited to the exemplary arrangement of Figure 2. For example, where the gearbox 30 has a star arrangement (described above), the skilled person would readily understand that the arrangement of output and support linkages and bearing locations would typically be different to that shown by way of example in Figure 2.

Accordingly, the present disclosure extends to a gas turbine engine having any arrangement of gearbox styles (for example star or planetary), support structures, input and output shaft arrangement, and bearing locations.

Optionally, the gearbox may drive additional and/or alternative components (e.g. the intermediate pressure compressor and/or a booster compressor).

Other gas turbine engines to which the present disclosure may be applied may have alternative configurations. For example, such engines may have an alternative number of compressors and/or turbines and/or an alternative number of interconnecting shafts. By way of further example, the gas turbine engine shown in Figure 1 has a split flow nozzle 20, 22 meaning that the flow through the bypass duct 22 has its own nozzle that is separate to and radially outside the core engine nozzle 20. However, this is not limiting, and any aspect of the present disclosure may also apply to engines in which the flow through the bypass duct 22 and the flow through the core 11 are mixed, or combined, before (or upstream of) a single nozzle, which may be referred to as a mixed flow nozzle. One or both nozzles (whether mixed or split flow) may have a fixed or variable area. Whilst the described example relates to a turbofan engine, the disclosure may apply, for example, to any type of gas turbine engine, such as an open rotor (in which the fan stage is not surrounded by a nacelle) or turboprop engine, for example. In some arrangements, the gas turbine engine 10 may not comprise a gearbox 30.

The geometry of the gas turbine engine 10, and components thereof, is defined by a conventional axis system, comprising an axial direction (which is aligned with the rotational axis 9), a radial direction (in the bottom-to-top direction in Figure 1), and a circumferential direction (perpendicular to the page in the Figure 1 view). The axial, radial and circumferential directions are mutually perpendicular.

As an example component, discs of the high pressure compressor 15 can be required to operate at elevated temperatures, for example perhaps 750 °C or more. Therefore, joining processes for this component, and others, have to be able to withstand such conditions. However, such components can be made of materials such as nickel based superalloys that can become sensitive to cracking if they are bulk heated to close to their melting temperature (perhaps around 1350°C or more). This leaves a relatively small temperature window in which the jointing processes can operate.

Conventional diffusion bonding operations require high temperatures, making them unsuitable for use in these types of situation. However, the present inventor has developed a method that permits diffusion bonding at below conventional diffusion bonding temperatures.

The present diffusion bonding method involves one or both of the faying surfaces of a joint being coated in a substantially thin, lamellar structure of layers of differing composition. The method exploits the enthalpy of mixing of these layers.

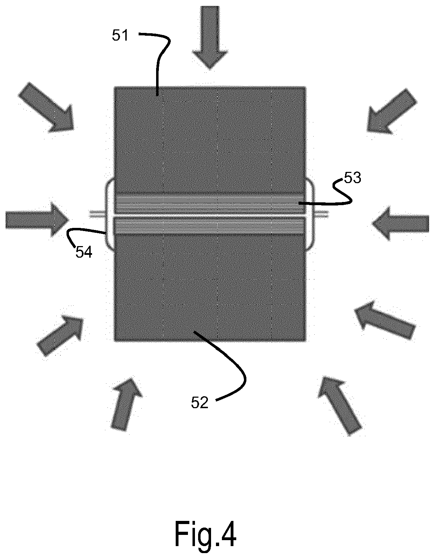

An example arrangement is shown schematically in Figure 4. First component 51 and second component 52 are to be joined together. They are shown with their faying surfaces provided with lamellar coatings 53. Each lamellar coating 53 comprises a plurality of layers, as discussed below. The faying surfaces are in a localised encapsulation arrangement 54 in this embodiment. Arrows are used to indicate that the process may occur under isostatic pressure, in order to consolidate any porosity.

By exploiting the enthalpy of mixing, the bulk component temperature, at least in the vicinity of the joint, can be elevated above ambient but below typical diffusion bonding temperatures. The skilled reader will appreciate that the specific temperatures used for conventional diffusion bonding will vary depending upon the materials being used. In any case, as the layers of dissimilar metals diffusely mix they generate heat. This local interfacial heating provides an additional pulse of heat for diffusion bonding above the background temperature of the first and second components 51, 52. As such, the volume of material above the background temperature is minimal, with minimal heat affected zones. Moreover, unlike a braze or transient liquid phase bond (TLP), there are no melting point depressants, which might otherwise diffuse along grain boundaries.

The use of the lamellar coating 53 provides a softer interface for enabling the diffusion bonding. Nonetheless, the layers of the lamellar coating 53 are preferably composed of the same elements as the bulk material of the components 51, 52 being joined (or, if dissimilar materials are being joined, the same elements as at least one of the components). Preferably, the bulk composition of the lamellar coating has substantially the same ratio of elements as the material being joined, although there may be some local variation within the lamellae.

It will be understood that the term 'lamellar coating' does not require that each layer within the coating 53 is necessary coextensive with the surrounding layers, nor that each layer is uniformly thick across its extent. Indeed, it will be readily understood that the technique may be extended to create more geometrically complex lamellar coatings, for example by use of masks or three-dimensional printing techniques, in which different layers may have different shapes and variable thicknesses. Sol-gel processing might be used to pre-position the interlayer material. Nonetheless, such variations will still have an essentially 'lamellar' structure in that they will be composed, at least locally, of layers of material above and below each other.

The lamellar coating can be applied in vacuum. Preferably, the layers can be formed by electron beam physical vapour deposition. Further, the faying surfaces can optionally remain in vacuum until insertion into the diffusion bonding vessel, to prevent oxidation, condensation or contamination.

The lamellar coating can be formed of thinly deposited lamellar layers of, for example, from 0.10 to 1.25 microns, optionally from 0.40 to 1.10 microns, and further optionally from 0.50 to 1.00 microns. The different layers may comprise different elements that, together, would comprise elements of one or more of the components being joined together.

In some embodiments, there are at least four layers in the lamellar coating. Optionally there may be 30 to 100 layers, or 100 to 1000 layers.

The total thickness of the lamellar coating can be from 10 to 70 microns, optionally from 20 to 60 microns, further optionally from 30 to 50 microns.

To promote the enthalpy of mixing, the different layers can be composed of different elements having different atomic radii, e.g. transition group elements of significantly varying atomic radius. That is, the layers may each substantially consist of a single element, or perhaps a mixture of elements, with an adjacent layer substantially consisting of an element or mixture of elements with a significantly different atomic radius.

Examples of elements having smaller atomic radii include Ni, Co, Cr, Fe & Mn (which have calculated atomic radii, according to the well known Clementi values, of 149, 152, 166, 156 and 161 pm respectively)¹.
¹ See, for example, the disclosure of: E Clementi, D L Raimondi, W P Reinhardt (1963) J. Chem. Phys. 38:2686.

Examples of elements have larger atomic radii include Zr, Nb, Hf, W and Ta (which have calculated atomic radii, according to the well known Clementi values, of 206, 198, 208, 193 and 200 pm respectively).

Taking the smallest 'large' atom (W) and the largest 'small' atom (Co) in these examples, it can be seen that the ratios of atomic radii between the larger element in one layer to the smaller element in the adjacent layer will be 1.16 or more for layers created from the elements listed.

Aluminium (Clementi radius: 118 pm) may also be used as a relatively smaller atom. However aluminium as a pure element is limited in its maximum processing temperature, and so a layer composed of a mixture of titanium and aluminium may be used to improve processibility.

During the diffusion bonding operation, the faying surfaces are pressed together at an elevated temperature. This temperature is below conventional diffusion bonding temperatures, and could be in the range of 800°C to 1100°C, for example. As mentioned above, the skilled reader will appreciate that the specific temperatures used for conventional diffusion bonding will vary depending upon the materials being used.

However, as the faying surfaces are pressed together, the layers of the lamellar coating(s) mix, and the latent heat of mixing is released to enable a local heating that allows the diffusion bonding to occur, without the bulk heating that might increase susceptibility to cracking.

Moreover, the pressure of the diffusion bonding operation will also act to counteract the differential strains. As such, this also contributes (in conjunction with the reduced overall exposure to elevated temperature) to reducing the opportunity for cracking in the components being joined.

In addition to the bulk heating, a local, secondary, heat source may optionally be used to initiate the diffusion bonding at a point in the joint. Such a heat source could be a chemical or electrical fuse, for example. Preferably, such a secondary heat source is used in a discardable region of the joint, i.e. a region to be machined off after the joining, to avoid any imperfections around the secondary heat source propagating into the final product.

One example of a lamellar coating that may be used for bonding two components of nickel based superalloy may including the following layers (in order):
- Ni
- Zr (i.e. much larger atoms than Ni)
- Ni
- Al (i.e. smaller atom than Ni)

In this example (and in the following examples), Ni is an example of a transition metal, and the other layers may be provided as a layer of the transition metal (i.e. Ni) enriched with noted element (e.g. the second layer may be a layer of Ni enriched with Zr). This allows for individual component elements to be provided without requiring a pure layer of a particular element.

A second example of a lamellar coating that may be used for bonding two components of nickel based superalloy may including the following layers (in order):
- Ni
- Ta (i.e. much larger atoms than Ni)
- Ni
- B (Clementi radius: 87 pm - i.e. much smaller atom than Ni)

A third example of a lamellar coating that may be used for bonding two components of nickel based superalloy may including the following layers (in order):
- Ni
- W (i.e. much larger atoms than Ni)
- Ni
- Ti (Clementi radius: 176 pm, as a substitution for Ni)
- Ni
- C (Clementi radius: 67 pm i.e. much smaller atom than Ni)

In these examples, the ratios of atomic radii between the larger element in one layer to the smaller element in the adjacent layer are all 1.18 or more, based on the Clementi radii.

The following Table 1 illustrates calculated values for enthalpy of mixing for a range of typical coating alloy compositions.

**Table 1 - Calculated values for enthalpy of mixing for a range of typical coating alloy compositions**

| Alloy | Elemental Composition | | | | | | | | | | | | | | | Enthalpy of mixing (J/kg) | | |
|---|---|---|---|---|---|---|---|---|---|---|---|---|---|---|---|---|---|---|
| | Ni | Cr | Co | Mo | Al | Ti | Ta | Hf | Zr | Nb | W | Mn | Si | Cu | Fe | 800°C | 900°C | 1000°C |
| A | 26 | 13 | 42 | 0 | 5 | 0 | 0 | 0 | 0 | 0 | 14 | 0 | 0 | 0 | 0 | -234061 | -229637 | -215771 |
| B | 28 | 10 | 40 | 3 | 4 | 5 | 2.5 | 0.5 | 0 | 1 | 5 | 0 | 1 | 0 | 0 | -374597 | -351982 | -319206 |
| C | 31 | 14 | 38 | 0 | 5 | 0 | 0 | 0 | 0 | 0 | 12 | 0 | 0 | 0 | 0 | -228950 | -216212 | -200478 |
| D | 35.7 | 22.5 | 23.5 | 1.4 | 6.5 | 5.5 | 1.5 | 0 | 0 | 2 | 1.4 | 0 | 0 | 0 | 0 | -558123 | -546354 | -525727 |
| E | 39 | 14 | 24 | 6.5 | 3 | 3.5 | 6 | 2 | 0 | 2 | 0 | 0 | 0 | 0 | 0 | -372477 | -350050 | -308743 |
| F | 37.4 | 15 | 25.5 | 3 | 6.5 | 3.6 | 2 | 0 | 0 | 2 | 1 | 1 | 1 | 0 | 2 | -566505 | -526188 | -477287 |
| G | 44 | 14 | 23 | 0 | 3 | 0 | 16 | 0 | 0 | 0 | 0 | 0 | 0 | 0 | 0 | -289015 | -276509 | -252135 |
| H | 44.7 | 15 | 20 | 6 | 2.5 | 3.4 | 1.4 | 1 | 0 | 2 | 2 | 0 | 2 | 0 | 0 | -389712 | -370102 | -339463 |
| I | 37 | 20 | 16 | 3 | 4 | 0 | 3 | 0 | 0 | 5 | 2 | 1 | 1 | 0 | 8 | -334130 | -291035 | -262027 |
| J | 52.3 | 15 | 18.5 | 5 | 3 | 3.6 | 2 | 0.5 | 0.1 | 0 | 0 | 0 | 0 | 0 | 0 | -305959 | -287949 | -263252 |
| K | 52.4 | 15 | 18.5 | 5 | 3 | 3.6 | 2 | 0.5 | 0 | 0 | 0 | 0 | 0 | 0 | 0 | -305082 | -286741 | -262527 |
| L | 52.5 | 19 | 1 | 3.1 | 0 | 0 | 2 | 0 | 0 | 3 | 0 | 0.4 | 0.4 | 0.2 | 18.5 | -53344 | -38904 | -28900 |
| M | 53.7 | 15.3 | 17 | 4.7 | 3.3 | 4.2 | 1.5 | 0.4 | 0.1 | 0 | 0 | 0 | 0 | 0 | 0 | -346240 | -332247 | -302028 |
| N | 57.6 | 12 | 14 | 1.4 | 6 | 4.5 | 1.5 | 0 | 0 | 1.5 | 1.5 | 0 | 0 | 0 | 0 | -570040 | -557493 | -518908 |
| O | 58.5 | 8 | 4 | 2 | 3 | 1 | 2 | 0.5 | 0 | 19 | 2 | 0 | 0 | 0 | 0 | -522258 | -512225 | -483774 |
| P | 67.1 | 8.3 | 9.3 | 0 | 5.6 | 0 | 0 | 0 | 0 | 0 | 9.5 | 0.1 | 0.3 | 0 | 0 | -377784 | -366467 | -349550 |
| Q | 84.6 | 0 | 0 | 0 | 6.5 | 3.6 | 1.5 | 0 | 0 | 2.5 | 1.3 | 0 | 0 | 0 | 0 | -524163 | -527389 | -527109 |

This diffusion bonding technique can find wide application, not just in making joins (e.g. to join compressor blades to disks), but also in repair applications, where the processing temperature can be limited.

Moreover, the technique is not limited to nickel based superalloys, although it has been exemplified in that context. The skilled person will understand that the technique is applicable to other types of alloys too, such as for aluminium alloys High Entropy Alloys (HEAs) and Eutectic High Entropy Alloys (EHEAs).

The technique could also be used, for example, in combination with a low-rated friction welding machine, where the frictional energy can be used for initial heating before the diffusion bonding.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and sub-combinations of one or more features described herein.

## Claims

1. A method of forming a diffusion bonded joint, the method comprising the steps of:
providing a first component (51) having a first faying surface;
providing a second component (52) having a second faying surface;
applying a lamellar coating (53) to at least one of the first faying surface and the second faying surface, the lamellar coating (53) comprising a plurality of layers of differing composition, the layers of the lamellar coating (53) being composed of the same elements as a bulk material of one or more of the first component (51) and the second component (52), the lamellar coating (53) having substantially the same ratio of elements as the bulk material of one or more of the first component (51) and the second component (52); and
bringing the first and second faying surfaces into contact in a diffusion bonding operation to form the diffusion bonded joint.

2. The method according to Claim 1, wherein the lamellar coating (53) comprises adjacent layers respectively comprising elements with different atomic radii.

3. The method according to Claim 2, wherein adjacent layers in the lamellar coating (53) comprise elements having a ratio of atomic radii of 1.15 or more, the ratio being defined as the ratio of larger elements to smaller elements based on calculated atomic radii, optionally 1.18 or more.

4. The method according to any one of the preceding claims, wherein the lamellar coating (53) has a thickness of from 10 to 70 microns, optionally from 20 to 60 microns, further optionally from 30 to 50 microns.

5. The method according to any one of the preceding claims, wherein individual layers within the lamellar coating (53) each have a thickness of from 0.10 to 1.25 microns, optionally from 0.40 to 1.10 microns, and further optionally from 0.50 to 1.00 microns.

6. The method according to any one of the preceding claims, wherein individual layers within the lamellar coating (53) are formed by electron beam physical vapour deposition.

7. The method according to any one of the preceding claims, further comprising applying the lamellar coating (53) in a vacuum.

8. The method according to Claim 7, further comprising maintaining the first and second faying surfaces in a vacuum between the step of applying the lamellar coating (53) and the step of bringing the first and second faying surfaces into contact in a diffusion bonding operation.

9. The method according to any one of the preceding claims, wherein the diffusion bonding operation is initiated by a local heat source at a part of the joint, such as a chemical or electrical fuse, or a radiant heat source.

10. The method according to Claim 9, further comprising removing the part of the joint at which the local heat source was applied.

11. The method according to any one of the preceding claims, wherein the diffusion bonding operation is performed under isostatic pressure.

12. The method according to any one of Claims 1 to 11, wherein the lamellar coating (53) comprises a layer of transition metal adjacent to a layer of transition metal enriched with Zirconium, adjacent to a further layer of transition metal, adjacent to a layer of transition metal enriched with Aluminium.

13. The method according to any one of Claims 1 to 11, wherein the lamellar coating (53) comprises a layer of transition metal adjacent to a layer of transition metal enriched with Tantalum, adjacent to a further layer of transition metal, adjacent to a layer transition metal enriched with Boron.

14. The method according to any one of Claims 1 to 11, wherein the lamellar coating (53) comprises a layer of transition metal adjacent to a layer of transition metal enriched with Tungsten, adjacent to a second layer of transition metal, adjacent to a layer of transition metal enriched with Titanium, adjacent to a third layer of transition metal, adjacent to a layer of transition metal enriched with Carbon.
